# FASCICULE DE BREVET EUROPEEN

(11) **EP 0 437 385 B1**
(45) Date de publication et mention de la délivrance du brevet: **01.03.1995**
(21) Numéro de dépôt: 91400015.3
(22) Date de dépôt: 04.01.1991
(51) Int. Cl.: H01L 33/00, H01S 3/06, H01S 3/19

(54) **Structure à semiconducteurs pour composant optoélectronique**
Halbleiterstruktur für optoelektronische Vorrichtung
Semiconductor structure for optoelectronic devices

(30) Priorité: 10.01.1990 FR 9000229
(43) Date de publication de la demande: 17.07.1991
(73) Titulaire: FRANCE TELECOM, 75015 Paris (FR)
(72) Inventeur: Gérard, Jean-Michel, F-75005 Paris (FR); Weisbuch, Claude, F-75013 Paris (FR)
(74) Mandataire: Martinet & Lapoux

(56) Documents cités:
- US-A- 4 205 329
- APPLIED PHYSICS LETTERS, vol. 53, no. 10, 5 septembre 1988, New York, US, pp. 854-855 ; M. Razeghi et al.: "First room-temperature cw operation of a GaInAsP/InP light-emitting diode on a silicon substrate"
- JOURNAL OF VACUUM SCIENCE AND TECHNOLOGY: PART B, vol. 6, no. 2, 3 avril 1988, New York, US, pp. 620-624 ; A. Fisher-Colbrie et al.: "Growth and characterization of A1GaAs/InGaAs/GaAs pseudomorphic structures"
- JAPANESE JOURNAL OF APPLIED PHYSICS, vol. 26, no. 3, mars 1987, Tokyo, JP, pp. L198-L199; H. Shiraishi et al.: "AlGaAs/GaAs MQW Laser Diode Fabricated on SiSubstrates by MOCVD"
- APPLIED PHYSICS LETTERS, vol. 42, no. 6, 15 mars 1983, New York, US, pp. 487-489; M.J. Ludowise et al.: "Continuous 300-K laser operation of strained superlattices"

## Description

La présente invention concerne une structure à plusieurs couches en matériau semiconducteur notamment pour laser à l'état solide. Plus généralement, l'invention trouve application en optoélectronique, et pour une bonne part au niveau de l'intégration monolithique de fonctions opto- et microélectroniques.

Le silicium Si et l'arséniure de gallium GaAs sont les matériaux semiconducteurs les plus employés actuellement. Si un très haut degré d'intégration a été obtenue en microélectronique au silicium, l'optoélectronique s'est, elle, développée à partir d'hétérostructures avec des matériaux semiconducteurs des groupes III et V de la classification de Mendeleiev, telles que GaAs/GaAlAs sur substrat de GaAs et telles que GaInAs/AlInAs ou GaInAs/InP sur substrat d'InP. L'intégration sur un même substrat de dispositifs optoélectroniques et microélectroniques ayant des fonctions complémentaires, mais réalisés à partir de matériaux différents, par exemple des matériaux des groupes III et V et du silicium, est une perspective particulièrement séduisante, qui a motivé un intense travail de recherche ces dernières années.

Un substrat en silicium présente de nombreux avantages: résistance mécanique, perfection, conductibilité thermique élevée, faible coût, etc. C'est la déposition de matériaux III-V sur silicium qui a été principalement étudiée. De nombreux progrès ont été réalisés concernant ce type de croissance épitaxiale et ont permis de vaincre partiellement les obstacles rencontrés : la difficulté de déposer un matériau polaire tel que semiconducteur III-V, sur un matériau non polaire, tel que silicium, et la grande différence de paramètre de maille entre ceux-ci, par exemple 4 % pour GaAs sur Si.

Ce désaccord implique en particulier la présence d'une très grande quantité de dislocations dans les premières dizaines de nanomètres du matériau épitaxié. Ces dislocations peuvent être dues à la préparation de l'état de la surface sur laquelle est effectuée la croissance épitaxiale, et/ou à une dégradation de la qualité cristallographique du semiconducteur épitaxié au cours du temps. Quelle que soit leur origine, les dislocations engendrent des inhomogénéités locales et peuvent évoluer.

Par exemple, lorsque le paramètre de maille cristalline dans une couche est inférieur à celui d'une seconde couche, la première couche est soumise à une tension et des dislocations naissent dans l'interface des couches. Si la première couche constitue la couche active d'un composant laser, les performances du composant laser dépendent fortement du nombre de dislocations présentes. Ces défauts affectent bien sûr le courant de seuil de ce composant à porteurs minoritaires, mais aussi son vieillissement. La présence d'un champ électrique, et de fortes densités de photons et de porteurs aident en effet, lors du fonctionnement du composant, le déplacement des défauts existants et assistent la génération de nouveaux défauts.

Pour les applications traditionnelles d'optoélectronique, des composants optoélectroniques sont réalisés à partir des hétérostructures de semiconducteurs III-V, telles que GaAs/GaAlAs sur substrat de GaAs et telles que GaInAs/AlInAs ou GaInAs/InP sur substrat d'InP. Les taux de dislocations obtenus lors de la croissance de ces structures par les techniques conventionnelles, comme l'épitaxie par jets moléculaires, et l'épitaxie en phase vapeur à partir d'organométalliques, sont de l'ordre de 10⁴/cm². Ces taux sont compatibles avec le bon fonctionnement de ces composants optoélectroniques, comme en témoigne l'utilisation commerciale à grande échelle de certains d'entre eux, tels que diodes laser GaAs/GaAlAs à longueur d'onde de 0,85 »m ; dans certains cas cependant, le déplacement et la multiplication des dislocations au cours du fonctionnement des composants ont pu être observés, et corrélés avec des problèmes de durée de vie de ces composants. Ces problèmes liés aux dislocations, latents dans le cas présent, deviennent cruciaux si ces défauts sont plus nombreux dans le matériau utilisé.

Dans le cas de la croissance d'un matériau III-V sur silicium, la recherche d'un taux de dislocations le plus faible possible dans la structure est donc primordiale. Les taux de dislocation dans la couche superficielle du matériau restent de l'ordre de 10⁶ à 10⁷ dislocations par cm². Le nombre de dislocations tend à décroître avec l'épaisseur du dépôt, mais on ne peut déposer plus de 4 à 5 micromètres de matériau. Au delà, la très grande différence de coefficients de dilatation entre le silicium et le matériau III-V entraîne la formation de nombreuses fissures dans la couche épitaxiée lors du passage de la température de croissance, de l'ordre de 500 à 600°C, à la température ambiante. Cet échec des tentatives de réduction du nombre de dislocations est lourd de conséquences en ce qui concerne la stabilité des composants lasers réalisés sur substrat en silicium.

Pour illustrer les résultats obtenus, on peut considérer le cas d'une structure à GaAs sur Si, qui a été le plus intensément étudiée. A l'heure actuelle, une observation d'émission en continu et à la température ambiante n'a jamais été rapportée pour des lasers à double hétérostructure, une dégradation du composant intervenant avant le seuil laser. Par contre, un fonctionnement en mode pulsé à la température ambiante, puis en continu sur de faibles durées de l'ordre de la minute a été observé pour des lasers à puits quantiques, c'est-à-dire des structures à confinement séparé par gradient d'indice. La réduction des dimensions de la couche active a donc un rôle clairement bénéfique sur le fonctionnement du composant optoélectronique. Ce résultat est lié à plusieurs facteurs favorables. L'utilisation du concept de confinement séparé conduit à une réduction du courant de seuil du composant, et donc à une stabilité accrue de celui-ci. Par ailleurs, la taille de la couche active, seul endroit de la structure où les deux types de porteurs sont simultanément présents, est réduite : la diffusion des porteurs avant recombinaison se fait maintenant dans un plan et les dislocations n'interviennent plus dans la capture des porteurs que par leur fragment de ligne qui intersecte la couche active. Cependant, même avec ces structures à puits quantiques, les composants obtenus sont peu stables, et présentent des problèmes marqués de durée de vie.

Le brevet US-A-4 205 329 décrit une structure à semiconducteurs obtenue par croissance épitaxiale. Cette structure fournit des avantages relatifs à la limite de bande du composant laser qu'elle constitue. La couche active de cette structure comprend plusieurs couches épitaxiées de Ge₂, et plusieurs ilots épitaxiés de AlₓGa₁₋ₓAₛ (0 ≦ x ≦ 1) qui sont formés par couches successives sur la surface principale de l'ensemble des couches de Ge₂.

L'invention vise à réduire l'influence des dislocations sur le fonctionnement des structures pour composant optoélectronique, tel que laser, réalisées à partir de matériaux semiconducteurs.

A cette fin, une structure à plusieurs couches en matériaux semiconducteurs selon l'invention est telle que définie dans la revendication 1. Les inclusions assurent une fonction de piégeage des porteurs, évitant ainsi une diffusion de ceux-ci vers le coeur des dislocations et les centres non radiatifs associés. Les inclusions sont le siège de la recombinaison radiative entre électrons et trous piégés conduisant au gain laser.

Les inclusions sont insérées au cours de la croissance du matériau constituant ladite couche, la croissance étant interrompue au moins deux fois pour déposer une fine couche du matériau semiconducteur constituant lesdites inclusions. L'insertion des dislocations utilise le mode de nucléation tridimensionnel observé lors de l'épitaxie de matériaux III-V qui sont très désaccordés par rapport au substrat utilisé.

D'autres avantages de la présente invention apparaîtront plus clairement à la lecture de la description d'une réalisation préférée de l'invention en référence aux dessins annexés correspondants dans lesquels :
- la Fig. 1 est une vue schématique en coupe transversale d'une structure de laser selon la technique antérieure ;
- la Fig. 2 est un diagramme épaisseur-énergie quantique de la structure selon la Fig. 1, en correspondance avec la ligne II-II ;
- la Fig. 3 est un diagramme épaisseur-indice de réfraction de la structure montrée à la Fig. 1, selon la ligne II-II ;
- la Fig. 4 est une vue schématique en coupe transversale d'une structure à plusieurs couches en matériaux semiconducteurs conforme à l'invention, d'un type analogue à celui de la Fig. 1 ;
- la Fig. 5 est une vue schématique de détail de la couche active dans la structure montrée à la Fig. 4 ;
- les Figs. 6 et 7 sont des diagrammes épaisseur-énergie quantique de la structure montrée à la Fig. 4, en correspondance avec les lignes VI-VI et VII-VII dans la Fig. 5 , respectivement; et
- les Figs. 8, 9 et 10 sont des vues schématiques en perspective de la structure de la Fig. 4 pour illustrer l'état de la couche active de la Fig. 5 avant et après dépôt d'inclusions dans un plan et après dépôt d'une sous-couche de couche active sur les inclusions, respectivement.

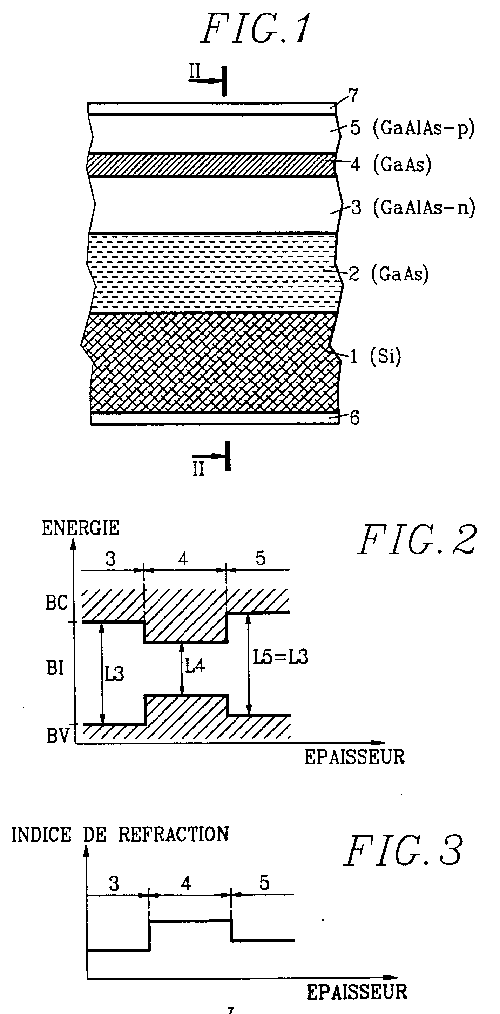

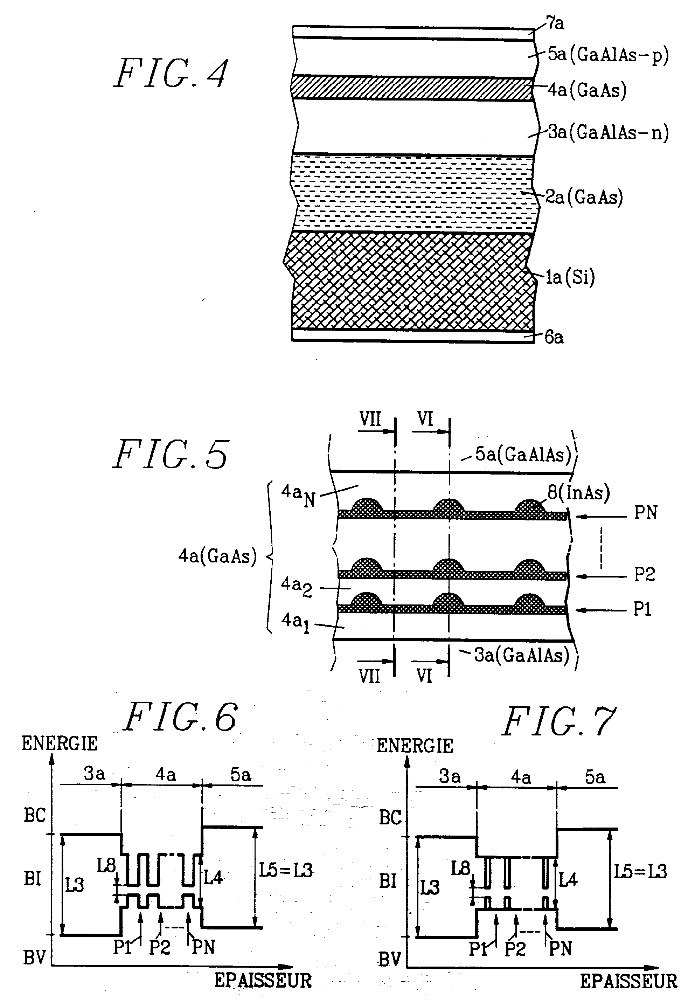

Comme cela apparaît par comparaison des Figs. 1 et 4, une structure d'un laser semiconducteur conforme à l'invention est analogue à une structure de laser connu à l'état solide. La structure connue comprend un substrat semiconducteur 1 et un empilement de trois ou quatre couches en matériau semiconducteur 2, 3, 4 et 5 disposé sur une face principale du substrat 1.

Selon la réalisation illustrée à la Fig. 1, quatre couches 2 à 5 sont prévues et constituent une double hétérostructure. Les couches 2 et 4 sont en matériau semiconducteur offrant des étroites bandes interdites BI entre bande de valence BV et bande de conduction BC, et des indices de réfraction élevés ; le matériau semiconducteur des couches 2 et 4 peut être du GaAs. Les deux autres couches 3 et 5 sont en matériau semiconducteur ayant des largeurs de bande interdite L3 et L5 plus grandes que la largeur de bande interdite L4 de la couche 4, comme montré aux Figs. 2 et 3, et des indices de réfraction faibles. Le caractère étroit des bandes interdites des couches 2 et 4 est ici défini relativement au caractère large des bandes interdites des couches 3 et 5. Dans ces conditions, les couches 3 et 5 confinent, comme il est connu, un faisceau laser se propageant dans la couche active 4 intermédiaire entre les couches 3 et 5.

Selon une réalisation préférée, l'empilement de couches 2 à 5 constitue une double hétérostructure GaAs /GaAlAs formée sur un substrat en silicium Si.

La couche 2 est du type monocouche ou multicouche et est epitaxiée directement sur ladite grande face du substrat 1 et est en GaAs. La couche 2 constitue une couche tampon aussi peu disloquées que possible qui vise uniquement à fournir un support accordé en maille à la structure laser proprement dite constituée par les couches 3, 4 et 5. Selon certaines variantes, la couche 2 peut être omise.

La couche active 4 est également en GaAs, et est interposée entre les couches épaisses 3 et 5 et plus mince que celles-ci.

Les couches 3 et 5 sont en l'alliage ternaire GaAlAs ayant un indice de réfraction plus faible que celui de la couche active 4 enterrée entre les couches 3 et 5. Les couches 3 et 5 sont dopées avec des impuretés de conductivité opposées, respectivement de type n et p. Ainsi des électrons et trous injectés sont confinés et se recombinent dans la couche active 4 qui assure le confinement de l'onde optique. Dans la couche 4 qui constitue le milieu actif du laser, de l'énergie est transférée à l'onde électromagnétique par la recombinaison des porteurs.

Pour être complet, on notera que l'invention peut s'appliquer à tout type de structure connue en matériaux semiconducteurs pour laser ou composants optoélectroniques tels que modulateurs optiques ou commutateurs optiques. En particulier, les couches de confinement 3 et 5 peuvent être constituées chacune par plusieurs couches du même matériau mais avec des concentrations de dopage différentes, et la couche supérieure 5 peut être recouverte d'autres couches en matériau semiconducteur différent et/ou de conductivité différente, voire de couche isolante telle que SiO₂ ou Si₃N₄. Bien entendu, de part et d'autre de l'empilement des couches sont prévues deux couches métalliques minces 6 et 7, formant électrodes.

En se reportant à la Fig. 4, la structure de laser semiconducteur selon l'invention comporte un substrat 1a, et des couches superposées 2a, 3a, 4a et 5a ainsi que des électrodes 6a et 7a qui sont agencés les uns par rapport aux autres de la même manière que le substrat 1, les couches 2 à 5 et les électrodes 6 et 7 dans la structure connue montrée à la Fig. 1. Toutes les couches, à l'exception de la couche 4a, sont identiques aux couches correspondantes dans la structure connue.

Selon l'invention, la couche active 4a est modifiée par rapport à la couche antérieure 4, par des inclusions ponctuelles 8 en un matériau semiconducteur, tel que l'arséniure d'indium InAs, ayant, comme montré à la Fig. 6, une largeur de bande interdite L8 plus petite que celle L4 du matériau semiconducteur de la couche active 4a, tel qu'arséniure de gallium GaAs. Comme montré en détail et schématiquement à la Fig. 5, les inclusions 8 d'InAs forment des ilôts sensiblement en calotte semi-sphérique qui sont répartis dans la couche 4a, avec une densité sensiblement uniforme, dans plusieurs plans parallèles aux couches de confinement 3a et 5a. Pour éviter toute surcharge de la Fig. 5, seulement trois plans P1, P2, PN d'inclusions 8 y ont été illustrés.

La fabrication du laser semiconducteur selon l'invention est analogue à celle d'un laser de même type selon la technique antérieure, à l'exception de l'étape de formation de la couche active 4a. L'ensemble de la structure du laser est réalisé par la même technique de croissance, par exemple l'épitaxie par jets moléculaires EJM, ou selon une autre variante par épitaxie en phase vapeur.

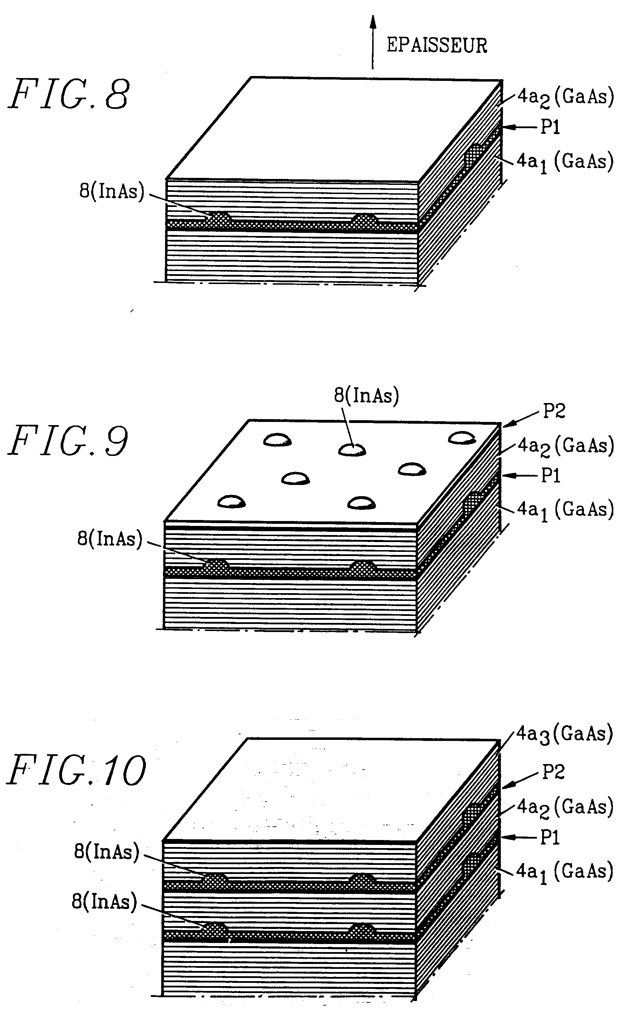

A la fin de la formation de la couche de confinement 3a, débute la croissance par épitaxie par jets moléculaires du matériau GaAs constituant la couche 4a. Lorsque l'épaisseur de cette couche 4a atteint chacun des plans P1 à PN, la croissance est interrompue à cet endroit de la structure, comme montré à la Fig. 8 pour le plan P2. Une fine couche d'InAs est déposée sur la surface de la "sous-couche" ainsi formée 4a₁, 4a₂,... de la couche active 4a. Le matériau, InAs, présente un fort désaccord de maille avec GaAs, de l'ordre de 7 %, ce qui influence fortement le mode de croissance d'InAs. La première couche moléculaire P1 d'InAs, en pratique ayant une épaisseur de 0,3 nm environ, accommode élastiquement cette différence de paramètre de maille. Cependant, dès la seconde monocouche, correspondant au plan P2, un passage à un mode de croissance tridimensionnel est observé à la température usuelle de croissance de 500 à 550°C. Des ilôts 8 d'arséniure d'indium InAs sont formés à la surface. Au cours d'une observation de ces ilôts au microscope électronique en transmission à balayage STEM (Scanning Transmission Electron Microscope), il est constaté que la taille des ilôt d'InAs est assez homogène, ainsi que la répartition des ilôts est relativement uniforme à la surface de l'échantillon, comme montré au niveau de la seconde sous-couche active 4a₂ à la Fig. 9. En pratique, chaque inclusion est inscrite dans un petit pavé de taille 5x5x2 nm³ environ, et les inclusions sont réparties dans un ou plusieurs plans, tels que les plans illustrés P1, P2 et PN à la Fig. 5. Après chaque dépôt d'inclusions dans un plan, la croissance épitaxiale de GaAs est à nouveau effectuée pour former une autre sous-couche active. Les inclusions 8 sont ainsi enterrées au sein de la couche active 4a. Les inclusions, contraintes dans la matrice de GaAs, ne contiennent cependant pas de dislocation.

Comme montré aux Figs. 6 et 7, l'arséniure d'indium InAs possède une énergie de bande interdite plus petite que celle de l'arsénuire de gallium GaAs. Les inclusions 8 sont donc plus attractives pour les électrons et les trous. Une étude en photoluminescence de structures d'InAs dans du GaAs montre que le piégeage des porteurs par les inclusions est très efficace, ce qui se traduit par une luminescence très intense liée aux inclusions, et une très faible contribution de la matrice en GaAs, et que la qualité optique de ces structures est très bonne. Une étude en transmission de ces structures montre que cette luminescence est intrinsèque, c'est-à-dire liée à la présence d'une forte densité d'états conjointe à l'énergie de luminescence. Enfin, la taille des inclusions et donc la position de la raie de luminescence associée dépendent de la quantité d'InAs déposée après le passage à un mode de croissance tridimensionnel.

En outre, la densité des inclusions 8 d'InAs dans un plan P1 à PN est très élevée, environ 10¹²/cm², et en particulier est très grande devant le nombre de dislocations dans les structures connues GaAs sur Si, typiquement de l'ordre de 10⁶/cm². Les inclusions 8 se trouvant à proximité d'une dislocation ne représentent donc qu'une infime fraction de leur population. Les porteurs injectés ont donc une très forte probabilité d'être piégés par une inclusion plutôt que par une dislocation, et par une inclusion intacte plutôt que par une inclusion perturbée par la proximité d'une dislocation. Enfin, la présence de zones fortement contraintes dans la structure autour des inclusions d'InAs peut inhiber la propagation des dislocations existantes.

Le facteur de confinement Γ, qui est défini comme la fraction de l'onde optique contenue dans la couche active 4a est faible pour la structure selon l'invention, alors qu'il est voisin de 1 dans la double hétérostructure comme montré à la Fig. 1. Pour un plan d'inclusions P1 à PN, le facteur de confinement est voisin de celui d'une structure à un mono-puits quantique de 0,6 nm de large. Par contre, le gain par unité de volume du milieu actif gᵥ augmente très fortement pour un tel laser à boîtes quantiques. Pour obtenir la même amplification de l'onde optique dans la cavité, le gain modal Γ.gᵥ doit être le même pour les deux structures. Il est alors nécessaire de multiplier les plans d'inclusions dans la structure pour augmenter le facteur de confinement optique. Cette exigence est satisfaite par exemple en formant N=10 à 40 plans P1 à PN d'inclusions 8 d'InAs dans une cavité de GaAs ayant une épaisseur de 200 nm.

Bien que la description ci-dessus se rèfère à une hétérostructure GaAs/GaAlAs, des inclusions dans la couche active d'autres hétérostructures connues peuvent être introduites selon l'invention. Parmi les hétérostructures d'alliages semiconducteurs des composés III-V, on peut citer les structures laser (InGa)As/(InAl)As ou (InGa)As/InP sur substrat très désaccordé Si ou GaAs. Ici des inclusions d'InAs peuvent être réalisées par le procédé selon l'invention. A la place d'alliage binaire ou ternaire peut être prévu un alliage quaternaire, tel que GaInAsP ou InGaAlAs. Le procédé selon l'invention est également mis en oeuvre dans des structures accordées lorsque le substrat utilisé disponible commercialement est de qualité insuffisante, c'est-à-dire offre un taux de dislocation élevé.

L'invention s'applique également aux structures laser habituellement utilisées pour optimiser le facteur de confinement optique et la collection des porteurs, telles qu'hétérostructures à confinement séparé, à confinement séparé par gradient d'indice,... etc.

Il est possible d'appliquer l'invention dans le cadre d'autres techniques de croissance, pour lesquelles un passage à un mode de croissance tridimensionnel est observé. La réalisation d'une structure laser GaAs sur Si à inclusions d'InAs est par exemple également possible en épitaxie en phase vapeur à partir d'organométalliques.

D'une manière générale, la présente invention permet de réduire la dégradation des performances de composants optoélectroniques dès lors que celle-ci est due aux dislocations, qu'il s'agisse de l'augmentation de leur nombre ou de leur propagation, puisque l'influence des dislocations est diminuée. Cet aspect est important pour l'application puissance des composants laser.

## Revendications

1. Structure à plusieurs couches en matériaux semiconducteurs (1a-5a), caractérisée en ce que l'une (4a) des couches formant la couche active d'un composant optoélectronique comprend des inclusions tridimensionnelles (8) en un matériau semiconducteur ayant une bande interdite (L8) plus étroite que la bande interdite (L4) du matériau de ladite couche (4a), lesdites inclusions étant ponctuelles et présentant une densité élevée comparativement à la densité de dislocations dans ladite couche active.

2. Structure conforme à la revendication 1, caractérisée en ce que lesdites inclusions (8) sont réparties dans plusieurs plans (P1 à PN) sensiblement parallèles.

3. Structure conforme à la revendication 1 ou 2, caractérisée en ce que la taille de chacune des inclusions est de l'ordre de 50 nm³.

4. Structure conforme à l'une quelconque des revendications 1 à 3, caractérisée en ce que les inclusions (8) sont en arséniure d'indium (InAs).

5. Structure conforme à l'une quelconque des revendications 1 à 4, caractérisée en ce que ladite couche (4a) comprenant lesdites inclusions (8) est en l'un des matériaux semiconducteurs suivants : InGaAs, GaAs, GaInAsP, InGaAlAs.

6. Procédé pour fabriquer la structure à plusieurs couches en matériaux semiconducteurs conforme à l'une quelconque des revendications 1 à 5, caractérisé en ce que, au cours de la croissance du matériau constituant ladite couche (4a), ladite croissance est interrompue au moins deux fois pour déposer une fine couche (P1 à PN) du matériau semiconducteur ayant une bande interdite plus étroite que la bande interdite du matériau de ladite couche (4a), et constituant lesdites inclusions.

7. Procédé conforme à la revendication 6, caractérisé en ce que ladite croissance résulte d'une épitaxie par jets moléculaires ou d'une épitaxie en phase-vapeur, notamment à partir d'organométallique.

## Patentansprüche

1. Mehrschichtstruktur aus Halbleitermaterial (1a bis 5a), dadurch gekennzeichnet, daß eine (4a) der Schichten, die die aktive Schicht eines opto-elektronischen Bestandteils bildet, dreidimensionale Einschlüsse (8) aus halbleitendem Material aufweist, welches ein schmaleres verbotenes Band (L8) besitzt als das verbotene Band (L4) des Materials der einen Schicht (4a), wobei die Einschlüsse punktuell sind und eine Dichte präsentieren, die im Vergleich zur Dichte der Versetzungen in der aktiven Schicht erhöht ist.

2. Struktur nach Anspruch 1, dadurch gekennzeichnet, daß die Einschlüsse (8) in mehreren, im wesentlichen parallelen Ebenen (P1 bis PN) verteilt sind.

3. Struktur nach Anspruch 1 oder 2, dadurch gekennzeichnet, daß die Größe jedes der Einschlüsse in der Größenordnung von 50 nm³ liegt.

4. Struktur nach einem der Ansprüche 1 bis 3, dadurch gekennzeichnet, daß die Einschlüsse (8) Indiumarsenid (InAs) sind.

5. Struktur nach einem der Ansprüche 1 bis 4, dadurch gekennzeichnet, daß die die Einschlüsse (8) enthaltende Schicht (4a) eine der folgenden Halbleitermaterialien ist: InGaAs, GaAs, GaInAsP, InGaAlAs.

6. Verfahren zur Herstellung einer mehrschichtigen Struktur aus Halbleitermaterial nach einem der Ansprüche 1 bis 5, dadurch gekennzeichnet, daß im Verlaufe des Aufwachsens des die eine Schicht (4a) bildenden Materials das Aufwachsen wenigstens zweimal zum Aufbringen einer dünnen Schicht (P1 bis PN) von die Einschlüsse bildendem Halbleitermaterial unterbrochen wird, welches ein schmaleres verbotenes Band aufweist als das verbotene Band des Materials der einen Schicht (4a).

7. Verfahren nach Anspruch 6, dadurch gekennzeichnet, daß das Aufwachsen aus einer Epitaxie mit Molekularstrahlen oder aus einer Epitaxie einer Dampfphase, insbesondere von der metallorganischen ausgehend, resultiert.

## Claims

1. Structure having plural layers in semiconductor material (1a, 5a), characterized in that one of the layers (4a) forming the active layer of a optoelectronic component comprises three-dimensional inclusions (8) in a semiconductor material having a narrower forbidden band (L8) than the forbidden band (L4) of the material of said layer (4a), said inclusions being pinpoint and presenting a high density comparatively to the discolation rate in said active layer.

2. Structure according to claim 1, characterized in that the said inclusions (8) are distributed over several substantially parallel planes (P1 to PN).

3. Structure according to claim 1 or 2, characterized in that the size of each of inclusions is in the region of 50 nm³.

4. Structure according of any one of claims 1 to 3, characterized in that the inclusions (8) are in indium arsenide (InAs).

5. Structure according to any one of claims 1 to 4, characterized in that said layer (4a) comprising said inclusions (8) is in one of the following semiconductor materials: InGaAs, GaAs, GaInAsP, InGaAlAs.

6. Method for fabricating the structure having plural layers in semiconductor material according to any one of claims 1 to 5, characterized in that, during the growth of the material constituting said layer (4a), said growth is interrupted at least twice for depositing a thin layer (P1 to PN) of the semiconductor material having a narrower forbidden band than the forbidden band of the material of said layer (4a) and constituting said inclusions.

7. Method according to claim 6, characterized in that said growth results from of a molecular beam epitaxy or of a vapor phase epitaxy, especially from organometallic compounds.
